Europäisches Patentamt

European Patent Office

Office européen des brevets

(11) Publication number: 0 343 000 B1

# EUROPEAN PATENT SPECIFICATION

(45) Date of publication of patent specification: 26.01.94    (51) Int. Cl.5: H03H 9/17

(21) Application number: 89305086.4

(22) Date of filing: 19.05.89

(54) Length-extensional piezo-electric resonator.

(30) Priority: 20.05.88 JP 124545/88

(43) Date of publication of application:
23.11.89 Bulletin 89/47

(45) Publication of the grant of the patent:
26.01.94 Bulletin 94/04

(84) Designated Contracting States:
CH DE GB LI

(56) References cited:

PATENT ABSTRACTS OF JAPAN, vol. 9, no.
89 (E-309)[1812], 18th April 1985; & JP-A-59
218 022 (KINSEKI K.K.) 08-12-1984

PATENT ABSTRACTS OF JAPAN, vol. 10, no.
82 (E-392)[2139], 2nd April 1986; & JP-A-60
226 205 (KINSEKI K.K.) 11-11-1985

PATENT ABSTRACTS OF JAPAN, vol. 8, no.
221 (E-271)[1658], 9th October 1984; & JP-
A-59 104 812 (KINSEKI K.K.) 16-06-1984

PATENT ABSTRACTS OF JAPAN, vol. 4, no.
87 (E-16)[569], 21st June 1980, page 10 F 16;
& JP-A-55 52 621 (MATSUSHIMA KOGYO
K.K.) 17-04-1980

(73) Proprietor: SEIKO ELECTRONIC COMPO-
NENTS LTD.
30-1, Nishitaga 5-chome
Sendai-shi Miyagi(JP)

(72) Inventor: Kimura, Fumio c/o SEIKO ELEC-
TRONIC COMPONENTS LTD
30-1 Nishitaga 5-chome
Taihaku-ku
Sendai-shi Miyagi-ken(JP)

(74) Representative: Miller, Joseph et al
J. MILLER & CO.
34 Bedford Row,
Holborn
London WC1R 4JH (GB)

**Description**

The present invention relates to a length-extensional piezo-electric resonator, e.g. a length-extensional quartz resonator having an oscillating frequency in the range of 1.04 MHz to 1.06 MHz. Such a resonator may for example, be used in an information processing device and in a communication device such as a microcomputer and a wireless telephone.

A length-extensional piezo-electric resonator is known for example from the PATENT ABSTRACTS OF JAPAN, vol. 9, no. 89 (E-309) [1812], 18.04.1985; & JP-A-59 218 022 (KINSEKI K. K.).

A length-extensional quartz resonator is designed to undergo dominant length-extensional oscillation accompanied by spurious flexural oscillations. The specific frequencies of the dominant and the spurious oscillations are determined according to the dimensional parameters of the resonator. When a spurious oscillation is coupled with or resonated to the dominant oscillation, the equivalent resistance of the resonator is abruptly increased so as to thereby impair the performance of the resonator.

An object of the present invention is, therefore, to arrange that the dimensions of the length-extensional resonator are such as to avoid coupling between the dominant and spurious oscillations, whereby to ensure stable oscillatory performance of the resonator.

According to the present invention, there is therefore provided a length-extensional piezo-electric resonator comprising: oscillating means arranged in operation to undergo a dominant length-extensional oscillation and having an oscillating frequency in the range from 1.04 MHz to 1.06 MHz; and frame means arranged to surround the oscillating means and having an overall outer length of 4000 $\mu$m ± 200 $\mu$m, the frame means including a pair of longitudinally extending frame portions connected to the oscillating means so as in operation to undergo flexural oscillation and having a width which is in the range from 110 $\mu$m to 260 $\mu$m and which is effective to substantially suppress spurious coupling between the dominant length-extensional oscillation and the flexural oscillation.

Preferably, the resonator is a quartz resonator.

The oscillating means preferably comprises a pair of longitudinally extending oscillating portions arranged linearly of and connected to each other so that the combined length thereof is within the range from 2585 $\mu$m to 2635 $\mu$m.

Preferably, a pair of supporting portions extend transversely from the linearly arranged longitudinally extending oscillating portions in opposite directions for connecting the oscillating portions to the respective supporting portions.

Preferably, the frame means has an integral rectangular form having the said overall outer length of 4000 $\mu$m ± 200 $\mu$m, and comprises a pair of longitudinal frame portions spaced in parallel to each other, a base portion connected to one end of each of the respective frame portions, and a bridge portion connected transversely between the other ends of the respective frame portions.

The invention is illustrated, merely by way of example, in the accompanying drawings, in which:-

Figure 1 is a plan view of a length-extensional quartz resonator in accordance with the present invention,

Figure 2 is a sectional view of the length-extensional quartz resonator of Figure 1 mounted in a housing;

Figure 3 is a partial plan view of the length-extensional quartz resonator of Figure 1, schematically illustrating its oscillation modes of dominant length-extensional oscillation and accompanied flexural oscillation;

Figure 4 is a diagram showing the frequency relations between the dominant length-extensional oscillation and the spurious frame flexural oscillations;

Figure 5A is a graph showing the resonant characteristic of a length-extensional quartz resonator not in accordance with the present invention;

Figure 5B is a graph showing the resonant characteristic of a length-extensional quartz resonator according to the present invention;

Figure 6A is a graph showing the frequency-temperature characteristic of a length-extensional quartz resonator not in accordance with the present invention; and

Figure 6B is a graph showing the frequency-temperature characteristic of a length-extensional quartz resonator according to the present invention.

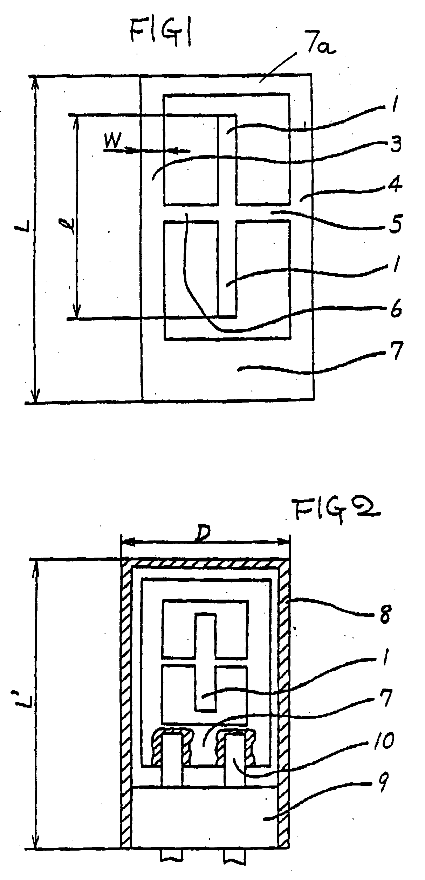

Figure 1 is a plan view showing the shape of a length-extensional quartz resonator according to the present invention. The resonator comprises a pair of oscillating portions 1 arranged linearly of each other, and a pair of frame portions 3 and 4 which surround the oscillating portions 1 and which are formed integrally with a base or mounting portion 7. The pair of oscillating portions 1 are centrally arranged between the opposite frame portions 3 and 4, and are connected at their junction to the respective frame portions 3 and 4 through a pair of crossing or transverse supporting portions 5 and 6 formed integrally with the other portions of the resonator. Such shape of the length-extensional quartz resonator is formed by etching a quartz water by photolithography. As shown in Figure 1, the linearly aligned oscillating portions 1 are surrounded by the frame portions 3, 4 and mounting portion 7. Further, the pair of frame portions 3 and 4 are preferably connected at their free ends to each other through a bridge portion 7a to thereby define a rectangular outer shape of the length-extensional quartz resonator.

Figure 2 is a sectional view of a housing accommodating therein the length-extensional quartz resonator of Figure 1. The housing comprises a cylindrical metal container or cap 8 having a diameter of 2mm and a 1ength of 6mm. The cap 8 has a closed top end portion and an open bottom end portion which is closed by a stem 9. The length-extensional quartz resonator is mounted inside the cap 8 by means of a pair of lead members 10. Each of the lead members 10 is fixed at one end thereof to the base or mounting portion 7 of the resonator by solder or electro-conductive adhesive, and extends outwardly of the cap 8 through the stem 9 for electrical connection to the outside.

The specific frequency, f(KHz) of the dominant oscillation of the length-extensional quartz resonator is determined according to the total length $\ell$ (Figure 1) of the linearly arranged oscillating portions 1 as indicated in the following equation (1):

$$f(KHz) \quad = \quad \frac{2740(KHz \cdot mm)}{\ell \ (mm)} \quad \cdots \quad (1)$$

Further, as indicated by Figure 2, the container 8 is designed to have a typical shape and dimensions for practical and general purposes so that the container 8 may have a cylindrical shape with an outer diameter D of 2.0mm and a length of L' of 6.0mm. In view of these dimensions of the container 8, the entire length L of the rectangular resonator is necessarily limited to L = 4000 $\mu$m + 200 $\mu$m as shown in Figures 1 and 2.

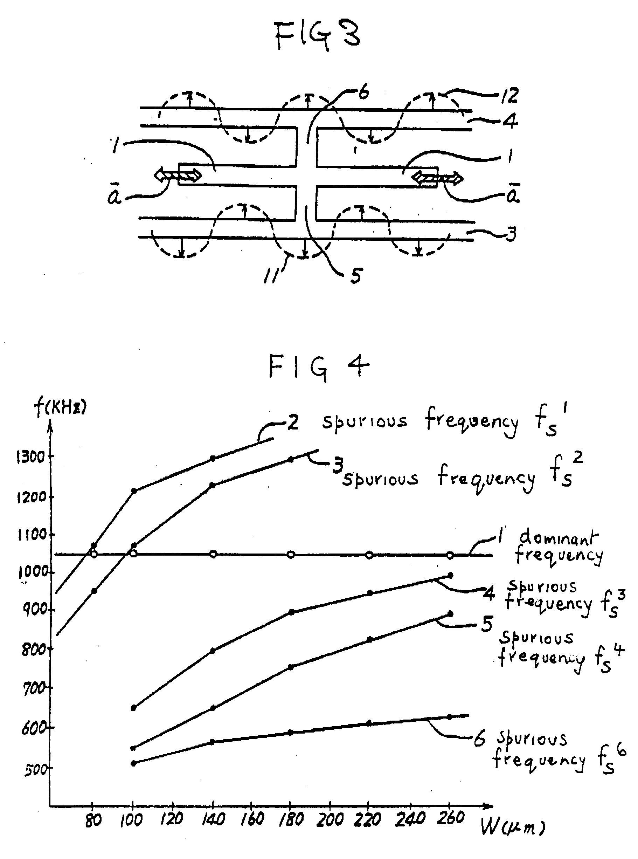

Figure 3 shows the oscillation modes of the length-extensional quartz resonator shown in Figure 1. As shown, the resonator comprises a pair of longitudinally extending oscillating portions 1 which are arranged linearly with respect to each other, a pair of longitudinally extending frame portions 3 and 4 which are arranged parallel to each other and parallel to the oscillating portions 1, and a pair of transverse supporting portions 5 and 6 each of which is connected between a respective frame portion 3, 4 and the mid junction of the pair of oscillating portions 1. The oscillating portions 1 undergo a dominant length-extensional oscillation displacement as indicated by the double headed arrow $\bar{a}$.

This displacement $\bar{a}$ is transmitted through the supporting portions 5 and 6 to the respective longitudinally extending frame portions 3 and 4 to induce therein flexural oscillations as illustrated by the dashed lines 11 and 12.

The specific frequency f of the dominant oscillation of the oscillating portions 1 is determined according to the equation (1) in the Figure 3 embodiment. Consequently, the frame portions 3 and 4 tend to undergo the flexural oscillations at a frequency identical to the specific frequency f of the oscillating portions 1. However, the frame portions 3 and 4 have their own specific frequency for the flexural oscillation independently from the oscillating portions 1. If the specific frequency of the frame portions 3 and 4 substantially coincides with that of the pure length-extensional oscillation of the oscillating portions 1, the equivalent resistance $R_1$ of the resonator is abruptly increased due to resonance so as to cause serious problems. Such a phenomenon is similar to the coupling phenomenon between a dominant oscillation and a spurious oscillation, which is observed in other types of quartz resonators, for example, typically in the AT cut quartz resonator.

However, with regard to the length-extensional quartz resonator, a theoretical or experimental analysis has not previously been undertaken with regard to the specific frequency of the spurious flexural oscillations of the frame portions. There has been no suggested design for a length-extensional quartz resonator effective to avoid the spurious oscillation and there has been the serious problem that the equivalent resistance $R_1$ of the resonator is abruptly increased due to the spurious oscillation. Therefore, it is particularly important to analyze the quantitative relationship between the specific frequency of the spurious oscillation of the frame portions and the specific frequency of the dominant length-extensional oscillation of the main oscillating portion in terms of the dimensions of the resonator, so as to enable a proper choice of such dimensions which will be effective to suppress the phenomenon of the spurious oscillation.

We have found that the quantitative and numerical relationship between the specific flexural oscillation of the frame portions and the dominant length-extensional oscillation of the main oscillating portion can be determined by experiment. Based on the results of such experiment, the dimensions of the resonator can be selected so as to stabilize or improve the equivalent resistance characteristic of a length-extensional quartz resonator.

Figure 4 is a graph showing the experimental relationship between the dominant frequency of the length-extensional oscillation and the spurious frequencies of the frame portions, the results shown in Figure 4 being obtained by varying the width W of the longitudinal frame portions 3 and 4 of the length-extensional quartz resonator shown in Figure 1. The curve 1 indicates the change of the dominant frequency f in terms of the width W of the frame portions. As shown, the dominant frequency f is substantially kept constant when the width W is changed. The dominant frequency f is typically 1.05 MHz in this embodiment. The curves 2-6 indicate the changes of various spurious frequency $f_s^1$ - $f_s^6$ in terms of the width W of the frame portions. The experimentally obtained results indicated in Figure 4 can be effectively applied to a length-extensional quartz resonator having an overall outer length L of 4000 $\mu$m±200 $\mu$m and the combined length $\ell$ of the main oscillating portions of 2585 $\mu$m to 2635 $\mu$m. For the range of combined length $\ell$ from 2585 $\mu$m to 2635 $\mu$m, the length-extensional quartz resonator undergoes a length-extensional oscillation at a frequency of about 1.040 MHz to 1.060 MHz.

In Figure 4, the spurious frequencies $f_s^2$ and $f_s^1$ indicated by the curves 3 and 2, respectively, have the same values to the dominant frequency f in the range of the width W from 80 $\mu$m to 100 $\mu$m . Further, in the range of the width W above 260 $\mu$m, the spurious frequency $f_s^3$, $f_s^4$ and $f_s^6$ approach the dominant frequency f as indicated by the curves 4, 5 and 6, respectively. Namely, a specific frequency of some spurious flexural oscillation of the frame portions coincides with that of the main oscillating portion in the range of width W between 80 $\mu$m and 100 $\mu$m and above 260 $\mu$m to thereby abruptly increase the equivalent resistance $R_2$. Accordingly, it is found that the width W of the frame portions should be set within the following range (2):

$$110 \ \mu m \leqq W \leqq 260 \ \mu m \qquad (2)$$

In a length-extensional quartz resonator having an overall outer length L of 4000 $\mu$m ± 200 $\mu$m and a dominant oscillating frequency in the range from 1040 KHz to 1060 KHz, the width W of the frame portions 3 and 4 is set within the range 110 $\mu$m ≦ W ≦ 260 $\mu$m to thereby eliminate the spurious oscillation due to the resonant flexural oscillation of the frame portions, so as to reduce the equivalent resistance $R_1$ of the resonator.

The length-extensional quartz resonator has an overall outer length L of 4000 $\mu$m ± 200 $\mu$m and a rectangular outer shape in which the pair of linearly arranged longitudinally extending oscillating portions 1 are surrounded by the pair of frames 3 and 4.

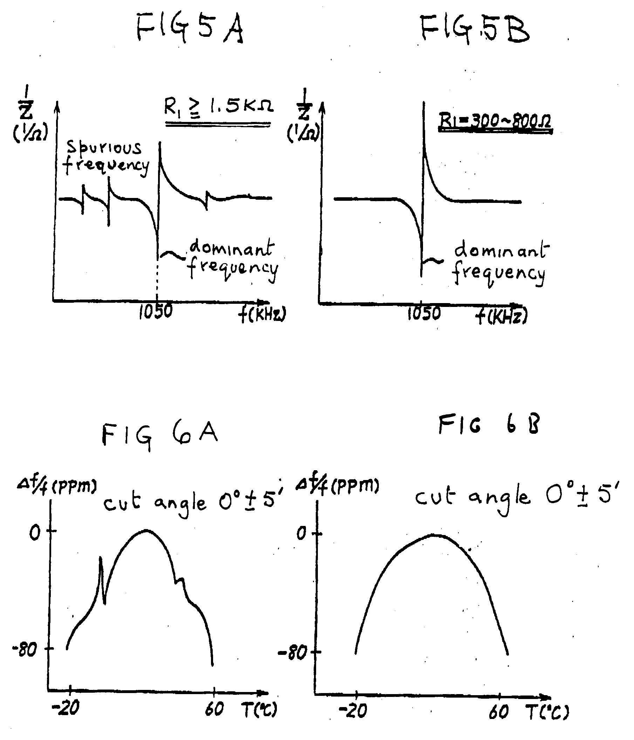

Figure 5A shows the resonant characteristic of a length-extensional quartz resonator which is not in accordance with the present invention. Namely, the width dimension of the frame portions is outside the optimum range referred to above, and the resonator has a plurality of resonant frequencies due to the spurious oscillation. On the other hand, Figure 5B shows the resonant characteristic of a length-extensional quartz resonator according to the present invention, in which the width W of the frame portions is in the range specified at (2). In the case of the resonator of Figure 5A which is not in accordance with the present invention, the resonant resistance or equivalent resistance $R_1$ is affected by the spurious oscillation and therefore has a value of at least 1.5 K $\Omega$, whereas in the case of the resonator of Figure 5B, which is in accordance with the present invention, the resonant resistance $R_1$ has the value of 300 $\Omega$ to 800 $\Omega$, which is not more than about half of the resonant resistance of the Figure 5A resonator. As described above, by setting the width dimensions of the frame portions within the desired range according to the invention, the optimum resonant resistance characteristic can be obtained.

Figure 6A shows the frequency-temperature characteristic of a length-extensional quartz resonator not in accordance with the present invention. The frequency-temperature characteristic curve is distorted by the spurious oscillation. On the other hand, Figure 6B shows the frequency-temperature characteristic of a length-extensional quartz resonator according to the present invention in which the width dimensions of the frame portions thereof are in the range specified at (2). The frequency-temperature characteristic curve is not distorted and the resonator can exhibit a good intrinsic temperature characteristic specific to a length-extensional quartz resonator. Thus, not only the optimum equivalent resistance characteristic can be obtained, but also the optimum frequency-temperature characteristic can also be obtained according to the present invention.

As described above, in a length-extensional quartz resonator whose oscillating frequency is in the range from 1.04 to 1.06 MHz and which has main oscillating portions surrounded by frame portions, if the width dimension W of the frame portions is within the range 110 $\mu$m ≦ W ≦ 260 $\mu$m, the following remarkable advantages are achieved:

(1) By setting the width of the frame portions to the optimum dimension, the coupling of the spurious oscillations can be substantially eliminated so as to reduce the equivalent resistance $R_1$.

(2) The intrinsic desired temperature characteristic can be obtained due to the substantial elimination of the coupling of the spurious oscillations.

## Claims

1. A length-extensional piezo-electric resonator comprising: oscillating means (1) arranged in operation to undergo a dominant length-extensional oscillation and having an oscillating frequency in the range from 1.04 MHz to 1.06 MHz; and frame means (3,4,7,7a) arranged to surround the oscillating means (1) and having an overall outer length (L) of 4000 $\mu$m ± 200 $\mu$m, the frame means (3,4,7,7a) including a pair of longitudinally extending frame portions (3,4) connected to the oscillating means (1) so as in operation to undergo flexural oscillation and having a width which is in the range from 110 $\mu$m to 260 $\mu$m and which is effective to substantially suppress spurious coupling between the dominant length-extensional oscillation and the flexural oscillation.

2. A resonator as claimed in claim 1 characterised in that the resonator is a quartz resonator.

3. A resonator according to claim 1 or 2 characterised in that the oscillating means comprises a pair of longitudinally extending oscillating portions (1) arranged linearly of and connected to each other so that the combined length ($\ell$) thereof is within the range from 2585 $\mu$m to 2635 $\mu$m.

4. A resonator according to claim 3 characterised in that a pair of supporting portions (5,6) extend transversely from the linearly arranged longitudinally extending oscillating portions (1) in opposite directions for connecting the oscillating portions (1) to the respective supporting portions (5,6).

5. A resonator according to claim 1; wherein the frame means (3,4,7,7a) has an integral rectangular form having the said overall outer length (L) of 4000 $\mu$m ± 200 $\mu$m and comprises a pair of longitudinal frame portions (3,4) spaced in parallel to each other, a base portion (7) connected to one end of each of the respective frame portions (3,4) and a bridge portion (7a) connected transversely between the other ends of the respective frame portions (3,4).

## Patentansprüche

1. Piezoelektrischer Längendehnungs-Resonator, umfassend: eine Schwingungseinrichtung (1), welche dazu eingerichtet ist, in Betrieb eine Längendehnungs-Grundschwingung mit einer Schwingungsfrequenz im Bereich von 1,04 MHz bis 1,06 MHz auszuführen; und eine Rahmeneinrichtung (3,4,7,7a), Welche dazu eingerichtet ist, die Schwingungseinrichtung (1) zu umgeben, und welche eine Gesamtaußenlänge (L) von 4000 $\mu$m ± 200 $\mu$m aufweist, wobei die Rahmeneinrichtung (3,4,7,7a) ein Paar sich longitudinal erstreckender Rahmenabschnitte (3,4) aufweist, welche mit der Schwingungseinrichtung (1) derart verbunden sind, daß sie in Betrieb Siegeschwingungen ausführen, und welche eine Breite im Bereich von 110 $\mu$m bis 260 $\mu$m aufweisen, die wirksam ist, eine unerwünschte Kopplung zwischen der Längendehnungs-Grundschwingung und der Biegeschwingung im wesentlichen zu unterdrücken.

2. Resonator nach Anspruch 1, dadurch gekennzeichnet, daß der Resonator ein Quarzresonator ist.

3. Resonator nach Anspruch 1 oder 2, dadurch gekennzeichnet, daß die Schwingungseinrichtung ein Paar sich longitudinal erstreckender Schwingungsabschnitte (1) umfaßt, welche derart linear zueinander angeordnet und miteinander verbunden sind, daß deren kombinierte Länge (1) im Bereich zwischen 2585 $\mu$m und 2635 $\mu$m liegt.

4. Resonator nach Anspruch 3, dadurch gekennzeichnet, daß sich ein Paar von Trägerabschnitten (5,6) quer zu den linear angeordneten, sich Längs erstreckenden Schwingungsabschnitten (1) in einander entgegengesetzten Richtungen erstreckt, um die Schwingungsabschnitte (1) mit den entsprechenden Trägerabschnitten (5,6) zu verbinden.

5. Resonator nach Anspruch 1, bei welchem die Rahmeneinrichtung (3,4,7,7a) eine zusammenhängende rechteckige Form aufweist, welche die Gesamtaußenlänge (L) von 4000 $\mu$m ± 200 $\mu$m hat, und ein

Paar in Abstand Parallel zueinander angeordneter, longitudinaler Rahmenabschnitte (3,4), einen mit einem Ende Jedes der entsprechenden Rahmenabschnitte (3,4) verbundenen Basisabschnitt (7) und einen quer zwischen den anderen Enden der entsprechenden Rahmenabschnitte (3,4) angeordneten und damit verbundenen Brückenabschnitt (7a) umfaßt.

**Revendications**

1. Résonateur piézo-électrique à extension longitudinale comportant des moyens oscillants (1) disposés de manière à ce qu'en fonctionnement ils subissent une oscillation d'extension longitudinale dominante, présentant une fréquence d'oscillation comprise entre 1,04 MHz et 1,06 MHz; et dos moyens cadres (3,4,7,7a) disposés de manière à entourer les moyens oscillants (1) et présentant une longueur externe totale (L) de 4000 $\mu$m + 200 $\mu$m, les moyens cadres (3,4,7,7a) comprenant une paire d'extensions longitudinales (3,4) reliées aux moyens oscillants (1) de sorte qu'en fonctionnement elles subissent des oscillations de flexion, ces extensions présentant une largeur comprise entre 110 $\mu$m et 260 $\mu$m et supprimant ainsi substantiellement le couplage résiduel entre une oscillation dominante d'extension longitudinale et une oscillation de flexion.

2. Résonateur selon la revendication 1, caractérisé par le fait que le résonateur est un résonateur à quartz.

3. Résonateur selon la revendication 1 ou la revendication 2, caractérisé en ce que les moyens oscillants comportent une paire de portions oscillantes s'étendant longitudinalement (1) disposées linéairement l'une par rapport à l'autre et reliées ensemble de sorte que la longueur combinée de celles-ci soit comprise entre 2585 $\mu$m et 2635 $\mu$m.

4. Résonateur selon la revendication 3, caractérisé par le fait que la paire de portions de support (5,6) s'étende transversalement par rapport aux portions oscillantes linéaires s'entendant longitudinalement (1) dans des directions opposées pour relier les portions oscillantes (1) aux parties de supports respectives (5,6).

5. Résonateur selon la revendication 1, caractérisé par la fait que les moyens cadres (3,4,7,7a) ont une forme rectangulaire intégrale présentant ladite longueur totale extérieure (L) de 4000um + 200um, et comportent une paire de parties longitudinales (3,4) espacées et parallèles l'une à l'autre, une partie de base (7) reliée à une extrémité de chacune des parties respectives de cadre (3,4) et un pont (7a) relié transversalement entre les autres extremités de ces parties de cadres respectives (3,4).

FIG 1

FIG 2

# FIG 3

# FIG 4

FIG 5A

$\frac{1}{Z}$ (1/Ω)

$R_1 \geqq 1.5 K\Omega$

Spurious frequency

dominant frequency

1050    f(KHz)

FIG 5B

$\frac{1}{Z}$ (1/Ω)

$R_1 = 300 \sim 800 \Omega$

dominant frequency

1050    f(KHz)

FIG 6A

Δf/f (PPm)

cut angle 0° ± 5'

0

-80

-20         60   T(°C)

FIG 6B

Δf/f (PPm)

cut angle 0° ± 5'

0

-80

-20         60   T(°C)